# EUROPEAN PATENT APPLICATION

(11) **EP 4 636 810 A1**
(43) Date of publication of application: **22.10.2025**
(21) Application number: 23903346.7
(22) Date of filing: 05.12.2023
(51) Int. Cl.: H01L 21/304, B23K 26/57, B23K 26/324, H01L 21/02, H01L 21/301, H01L 21/683, H01L 27/12

(54) **METHOD FOR MANUFACTURING SEMICONDUCTOR DEVICE**

(30) Priority: 14.12.2022 JP 2022199580
(71) Applicant: Tazmo Co., Ltd., Okayama-shi, Okayama 701-1221 (JP)
(72) Inventor: IKAGAWA, Yoshinori, Okayama-shi, Okayama 701-1221 (JP); YAMABE, Hiroshi, Okayama-shi, Okayama 701-1211 (JP); WICKRAMANAYAKA, Sunil, Singapore 179803 (SG)
(74) Representative: Knöner, Gregor
(86) International application number: PCT/JP2023/043371
(87) International publication number: WO 2024/128057

(57) **Abstract**

A method of manufacturing a semiconductor device comprises a dividing layer forming step, a fixing part forming step, and a dividing step. The dividing layer forming step forms a dividing layer in a position at a predetermined depth from a surface of a first substrate containing semiconductor as a main component thereof. The dividing layer is for allowing a semiconductor substrate having a thickness corresponding to the predetermined depth to be divided from the first substrate. The fixing part forming step forms a fixing part after the dividing layer forming step. The fixing part is for fixing a part of the first substrate to become the semiconductor substrate to a second substrate, and is formed into a ring shape in an atmosphere at a lower pressure than a predetermined pressure, thereby sealing the interior of the ring shape. The dividing step divides the first substrate at the dividing layer in an atmosphere at the predetermined pressure after the fixing part forming step.

## Description

### Technical Field

The present invention relates to a technique of manufacturing a semiconductor device.

### Background Art

A technique as one of existing techniques of manufacturing semiconductor devices includes a process of forming a semiconductor substrate having an intended thickness (a thickness of equal to or less than 150 µm, for example) by polishing a semiconductor wafer (a wafer having a thickness about 300 µm, for example).

Attention is being given in recent years to wide bandgap (WBG) materials such as GaAs, SiC, GaN, AlN, BN, and diamond that are semiconductor materials to allow semiconductor devices to operate normally even in a high temperature reaching 300°C. The WBG materials are also semiconductor materials allowing increase in a switching speed and in this regard, are expected to be used as materials for semiconductor devices for high-speed communication. The WBG materials are also semiconductor materials having tolerance to high electric fields and in this regard, are expected to be used as semiconductor materials for high voltages. In this way, the WBG materials as materials for semiconductor devices have advantages in terms of various aspects.

On the other hand, the WBG materials are expensive materials. Nevertheless, if a semiconductor substrate made of the WBG material is formed by polishing a semiconductor wafer, a part of the semiconductor wafer removed by the polishing is wasted to cause substantial increase in manufacturing cost.

According to a technique suggested to prevent such waste, hydrogen ions are implanted into a semiconductor wafer from a surface thereof to form a dividing layer in the semiconductor wafer and the semiconductor wafer is divided at the dividing layer, thereby forming a semiconductor substrate (see Patent literature 1, for example). Such a technique makes it possible to manufacture the thin semiconductor substrate without wasting the semiconductor material which the semiconductor wafer is composed of.

### Citation List

### Patent Literature

Patent literature 1: Japanese published unexamined patent No. 2007-250576

### Summary of Invention

### Technical Problem

According to the foregoing technique of forming the semiconductor substrate by implantation of the hydrogen ions, a part to become the semiconductor substrate is required to be held by a support (such as a glass substrate) during division of the semiconductor wafer at the dividing layer. Meanwhile, the semiconductor substrate after being divided from the semiconductor wafer is exposed to a high-temperature atmosphere while being kept held by the support, for example, in a process of forming a circuit in the semiconductor substrate. Hence, while the semiconductor wafer and the support are required to be joined to each other for holding the semiconductor substrate using the support, it is difficult to select an adhesive agent as means for the joining.

In response to this, according to means (direct joining method) conventionally employed as means of the joining between the semiconductor wafer and the support, CMP (chemical mechanical polishing) is performed on respective joint surfaces of the semiconductor wafer and the support and then the joint surfaces are directly affixed to each other, thereby providing coupling between the joint surfaces over the entire areas thereof by means of interatomic forces or intermolecular forces.

However, the joining using CMP causes problems such as (1) A problem that the CMP process involves high cost and (2) A problem that, as the semiconductor wafer and the support are to be firmly coupled to each other, a process of scraping off the support by polishing or the like is required if the support is intended to be removed from the semiconductor substrate after being divided from the semiconductor wafer.

Thus, in a technique of manufacturing a semiconductor device including a process of forming a semiconductor substrate using a dividing layer, the present invention is intended to facilitate handling of the semiconductor substrate after formation of the semiconductor substrate.

### Solution to Problem

A method of manufacturing a semiconductor device according to the present invention comprises a dividing layer forming step, a fixing part forming step, and a dividing step. The dividing layer forming step forms a dividing layer in a position at a predetermined depth from a surface of a first substrate containing semiconductor as a main component thereof. The dividing layer is for allowing a semiconductor substrate having a thickness corresponding to the predetermined depth to be divided from the first substrate. The fixing part forming step forms a fixing part after the fixing part forming step. The fixing part is for fixing a part of the first substrate to become the semiconductor substrate to a second substrate, and is formed into a ring shape in an atmosphere at a lower pressure than a predetermined pressure, thereby sealing the interior of the ring shape. The dividing step divides the first substrate at the dividing layer in an atmosphere at the predetermined pressure after the fixing part forming step.

According to the above manufacturing method, in the fixing part forming step, by forming the ring-shape fixing part in the atmosphere at the lower pressure than the predetermined pressure (barometric pressure, for example), in the atmosphere at the predetermined pressure (an atmosphere to be used in the dividing step), it becomes possible to generate a pressure difference between a pressure inside the ring shape of the fixing part (inside pressure) and a pressure outside the ring shape (outside pressure). This eventually allows generation of attractive force resulting from the pressure difference and acting between the first substrate and the second substrate. Thus, in the atmosphere at the predetermined pressure, the first substrate and the second substrate can be firmly joined to each other by means of joining force exerted by the fixing part and the attractive force resulting from the pressure difference between the inside pressure and the outside pressure. This makes it possible to obtain joining force sufficient for holding the semiconductor substrate on the second substrate after the semiconductor substrate is divided from the first substrate in the dividing step without the need of providing coupling between the first substrate and the second substrate over the entire areas of the respective joint surfaces (namely, without the need of performing joining using CMP) unlike in the conventional case.

### Advantageous Effects of Invention

According to the present invention, in a technique of manufacturing a semiconductor device including a process of forming a semiconductor substrate using a dividing layer, handling of the semiconductor substrate is facilitated after formation of the semiconductor substrate.

### Brief Description of Drawings

FIG. 1 is a conceptual view showing a manufacturing method according to an embodiment in order in which processes are performed.
FIG. 2 is a conceptual view showing processes in order in which the processes are performed subsequent to those in FIG. 1.
FIG. 3 is a plan view showing the shape of a fixing part formed in the embodiment.
FIG. 4 is a conceptual view showing a manufacturing method according to a first modification in order in which processes are performed.
FIG. 5A is a conceptual view showing a dividing layer forming step performed in a manufacturing method according to a second modification, and FIG. 5B is a conceptual view showing a comparative example.
FIG. 6 is a conceptual view showing part of a manufacturing method according to a fourth modification in order in which processes are performed.
FIG. 7 is a plan view showing the shape of a fixing part formed in the fourth modification.
FIGS. 8A and 8B are a conceptual view and a plan view respectively showing a further modification of the manufacturing method in FIGS. 6 and 7.
FIG. 9 is a plan view showing a first example of the shape of a fixing part Q formed in a fifth modification.
FIGS. 10A and 10B are plan views showing a second example and a third example of the fixing part Q respectively formed in the fifth modification.
FIG. 11A is a conceptual view showing a fixing part forming step and a cutting step performed in a manufacturing method according to a sixth modification, and FIG. 11B is a plan view showing the shape of a fixing part formed in the sixth modification.
FIG. 12 is a conceptual view showing a cutting step and a detaching step performed in a manufacturing method according to an eighth modification.

### Description of Embodiments

A method of manufacturing a semiconductor device according to the present invention will be shown below by describing its embodiment and modifications in detail. The manufacturing method described below can be implemented using various types of well-known apparatuses.

### [1] Embodiment

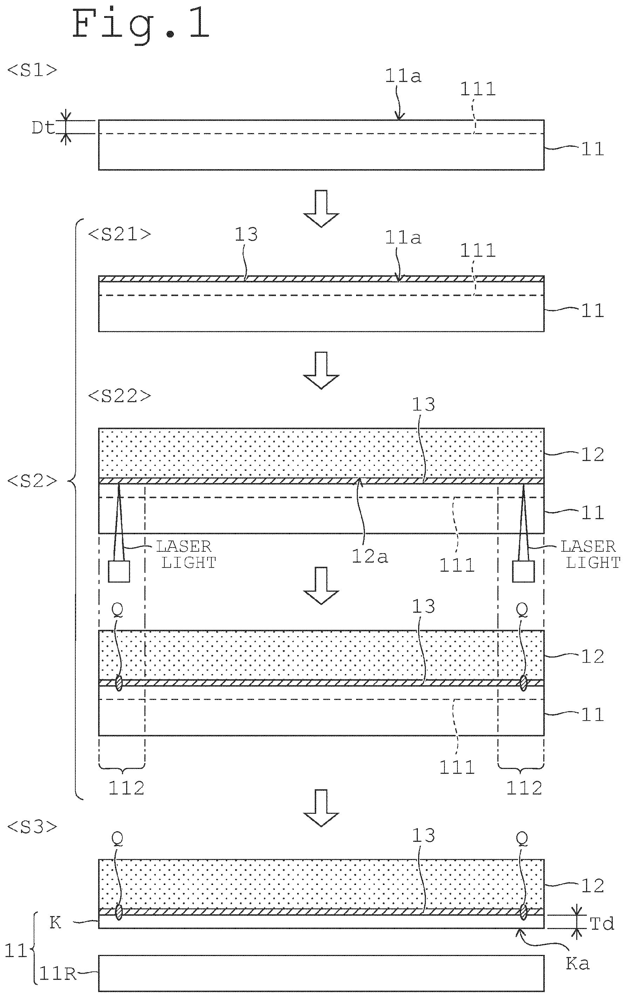

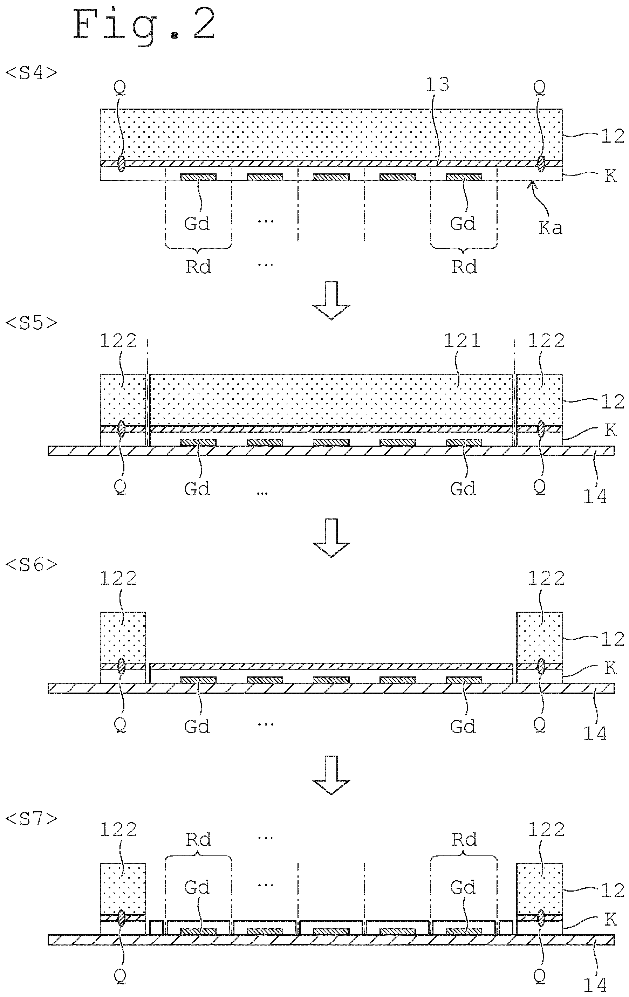

FIGS. 1 and 2 are conceptual views showing the manufacturing method according to the embodiment in order in which processes are performed. In this manufacturing method, a dividing layer forming step S1, a fixing part forming step S2, a dividing step S3, a device forming step S4, a cutting step S5, a detaching step S6, and a singulating step S7 are performed in this order. Each of the steps will be described below in detail.

### <Dividing Layer Forming Step S1>

In the dividing layer forming step S1 (see FIG. 1), a dividing layer 111 is formed in a position at a predetermined depth Dt from a surface 11a of a first substrate 11 containing semiconductor as a main component thereof. While not particularly limited here, the first substrate 11 is a single-crystalline semiconductor wafer, for example, and a wide bandgap (WBG) material such as GaAs, SiC, GaN, AlN, BN, or diamond may be used as the main component (semiconductor) thereof. The dividing layer 111 is a layer for allowing a semiconductor substrate K having a thickness Td corresponding to the predetermined depth Dt to be divided from the first substrate 11, and can be formed by implantation of hydrogen ions into the first substrate 11 from the surface 11a. The method of implanting hydrogen ions allows formation of the dividing layer 111 in a position at a depth of about 10 µm from the surface 11a or in a shallower position, and this eventually makes it possible to obtain the thin semiconductor substrate K having the thickness Td.

Here, instead of the method of implanting hydrogen ions, a method of applying laser light to a position at the predetermined depth Dt from the surface 11a as a focal point may be used for forming the dividing layer 111. According to this method, as the position of a focal point can be changed in a depth direction, it is possible to form the dividing layer 111 in a position at an intended depth. Thus, the method of applying laser light allows the dividing layer 111 to be formed in a deeper position (a position at a depth from about 50 to 150 µm from the surface 11a, for example) than the method of implanting hydrogen ions, and this eventually makes it possible to obtain the semiconductor substrate K having the large thickness Td.

The first substrate 11 is divided at the dividing layer 111 in the dividing step S3 described later. As a result, the semiconductor substrate K having the thickness Td corresponding to the predetermined depth Dt is divided from the first substrate 11. Here, during division of the first substrate 11, a part to become the semiconductor substrate K is required to be held by a support. Then, in the subsequent fixing part forming step S2, a second substrate 12 to become the support is joined to the surface 11a of the first substrate 11.

### <Fixing Part Forming Step S2>

While not particularly limited, the second substrate 12 is a polycrystalline semiconductor wafer, for example, and a wide bandgap (WBG) material such as GaAs, SiC, GaN, AlN, BN, or diamond may be used as a main component (semiconductor) thereof. Instead of the semiconductor wafer, a substrate made of a different material (such as Si, sapphire, or quartz) not limited to semiconductor may be used as the second substrate 12.

In the fixing part forming step S2, a fixing part Q is formed. The fixing part Q is for fixing a part of the first substrate 11 to become the semiconductor substrate K to the second substrate 12, and is formed into a ring shape in an atmosphere at a lower pressure than a predetermined pressure Pt, thereby sealing the interior of the ring shape. While the predetermined pressure Pt mentioned herein is a pressure in an atmosphere to be used in the dividing step S3 described later and is not particularly limited, it is a barometric pressure, for example.

More specifically, in the fixing part forming step S2 (see FIG. 1), a metal layer forming step S21 and a laser light applying step S22 are performed in this order.

In the metal layer forming step S21, a metal layer 13 is formed on the entire surface 11a of the first substrate 11. While not particularly limited, the metal layer 13 is formed into a thickness of equal to or less than 1 µm using a film deposition method such as a vapor deposition method. A metal such as Cu, Al, Cr, Ti, Ta, or Au may be used as a main component of the metal layer 13.

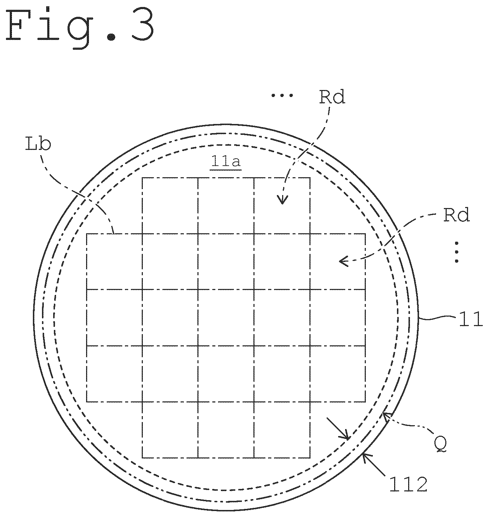

Then, in the laser light applying step S22, the first substrate 11 and the second substrate 12 are brought to face each other in such a manner that the metal layer 13 is interposed therebetween. In this state, laser light is applied to a part of the metal layer 13 where the fixing part Q is planned to be formed (in the present embodiment, a part on a periphery 112 of the first substrate 11, as will be described later in detail (see FIG. 3)), thereby heating this part. In doing this, the first substrate 11 and the second substrate 12 may be interposed under pressure using quartz plates, for example, in order to increase a degree of tight contact of each of the first substrate 11 and the second substrate 12 with the part of the metal layer 13 where the fixing part Q is planned to be formed.

By the application of the laser light to the metal layer 13 described above, in the part where the laser light is applied (the part where the fixing part Q is planned to be formed), it becomes possible to melt the metal layer 13 together with the first substrate 11 and the second substrate 12 or diffuse the metal as the main component of the metal layer 13 into the first substrate 11 and the second substrate 12. As a result, a compound (such as metal silicide) or an alloy (such as an alloy of metal and Si) of the metal and the main component (such as semiconductor) of each of the first substrate 11 and the second substrate 12 is formed at an interface between the metal layer 13 and each of the first substrate 11 and the second substrate 12, thereby forming the fixing part Q for firmly coupling the first substrate 11 (the part thereof to become the semiconductor substrate K) and the second substrate 12 to each other.

By forming the above fixing part Q continuously into a ring shape in the atmosphere at the lower pressure than the predetermined pressure Pt, the interior of the ring shape is sealed while being kept in the lower pressure than the predetermined pressure Pt.

FIG. 3 is a plan view showing the shape of the fixing part Q formed in the present embodiment. As shown in FIG. 3, in the present embodiment, the fixing part Q is formed at the periphery 112 of the first substrate 11 (more specifically, a periphery of the part of the first substrate 11 to become the semiconductor substrate K, also see FIG. 1) in such a manner as to be formed over an entire perimeter of the periphery 112. In the example in FIG. 3, the first substrate 11 has a circular disk shape and the fixing part Q is formed in a circular ring shape along the periphery 112 of the first substrate 11.

The shape of the fixing part Q is not limited to a circular ring shape but may be changed to a different ring shape (such as a polygonal shape), as appropriate, in response to the peripheral shape of the first substrate 11. If the fixing part Q is formed at the periphery 112 of the first substrate 11 like in the present embodiment, formation of the metal layer 13 in the metal layer forming step S21 is not limited to a case where the metal layer 13 is formed on the entire surface 11a of the first substrate 11 but the metal layer 13 may be formed only on a region of the surface 11a over the periphery 112 or the metal layer 13 may be formed only on a part of the surface 11a where the fixing part Q is planned to be formed. Furthermore, in the metal layer forming step S21, instead of forming the metal layer 13 on the surface 11a of the first substrate 11, the metal layer 13 may be formed on a surface 12a of the second substrate 12. In this case, formation of the metal layer 13 in the metal layer forming step S21 is also not limited to a case where the metal layer 13 is formed on the entire surface 12a of the second substrate 12 but the metal layer 13 may be formed only on a region of the surface 12a to face the periphery 112 or the metal layer 13 may be formed only on a part of the surface 12a where the fixing part Q is planned to be formed.

According to the above fixing part forming step S2, by forming the ring-shape fixing part Q in the atmosphere at the lower pressure than the predetermined pressure Pt (barometric pressure, for example), in an atmosphere at the predetermined pressure (an atmosphere to be used in the dividing step S3 described later), it becomes possible to generate a pressure difference between a pressure inside the ring shape of the fixing part Q (inside pressure) and a pressure outside the ring shape (outside pressure). This eventually allows generation of attractive force resulting from the pressure difference and acting between the first substrate 11 and the second substrate 12. Thus, in the atmosphere at the predetermined pressure Pt, the first substrate 11 and the second substrate 12 can be firmly joined to each other by means of joining force exerted by the fixing part Q and the attractive force resulting from the pressure difference between the inside pressure and the outside pressure. This makes it possible to obtain joining force sufficient for holding the semiconductor substrate K on the second substrate 12 after the semiconductor substrate K is divided from the first substrate 11 in the dividing step S3 described later without the need of providing coupling between the first substrate 11 and the second substrate 12 over the entire areas of the respective joint surfaces (namely, without the need of performing joining using CMP) unlike in the conventional case.

Thus, if the fixing part Q is formed into a ring shape along the periphery 112 like in the present embodiment, the periphery 112 of the semiconductor substrate K can be held by the second substrate 12 by means of the joining force exerted by the fixing part Q, and at the same time, a part of the semiconductor substrate K inside the fixing part Q (a part to which a plurality of device regions Rd is to be provided) can be held by the second substrate 12 by means of the attractive force resulting from the pressure difference. As a result, it becomes possible to hold the semiconductor substrate K using the second substrate 12 with sufficient joining force.

### <Dividing Step S3>

In the dividing step S3 (see FIG. 1), the pressure in the atmosphere is adjusted to become the predetermined pressure Pt (barometric pressure, for example). By doing so, the part of the first substrate 11 to become the semiconductor substrate K is held on the second substrate 12 with sufficient joining force (the joining force exerted by the fixing part Q and the attractive force resulting from the pressure difference between the inside pressure and the outside pressure). Then, in the dividing step S3, the first substrate 11 is divided at the dividing layer 111 in this atmosphere at the predetermined pressure Pt.

By doing so, the semiconductor substrate K having the thickness Td corresponding to the depth where the dividing layer 111 is formed (predetermined depth Dt) is divided from the first substrate 11 while being kept held by the second substrate 12. The resultant semiconductor substrate K is subjected to the device forming step S4 described below. Meanwhile, a residual part 11R of the first substrate 11 other than the semiconductor substrate K (a residual part after the division) is reused for manufacture of a new semiconductor substrate K and a new semiconductor device.

### <Device Forming Step S4>

In the device forming step S4 (see FIG. 2), at least a part (hereinafter called an "element Gd") of an element to be provided to a semiconductor device is formed in each of the device regions Rd (also see FIG. 3) provided in the semiconductor substrate K. While not particularly limited, in the device forming step S4, the element Gd such as an MOSFET or a Schottky diode can be formed in each device regions Rd. Before forming the element Gd in the semiconductor substrate K, a surface Ka of the semiconductor substrate K (a surface exposed as a result of the division at the dividing layer 111) may be polished to adjust smoothness (surface roughness) on the surface Ka to smoothness required for formation of the element Gd in the semiconductor substrate K.

In many cases, the above device forming step S4 is performed in a high temperature exceeding 1000°C. Here, it is assumed that the semiconductor substrate K has an expansion coefficient differing from the expansion coefficient of the second substrate 12. In this case, if the semiconductor substrate K and the second substrate 12 were coupled to each other over the entire areas of the respective joint surfaces (namely, if joining was performed using CMP) like in the conventional case, such coupling between the entire areas of the joint surfaces would cause one substrate of the semiconductor substrate K and the second substrate 12 having the larger expansion coefficient to pull the other substrate and make the other substrate try to expand more than its expansion coefficient, or conversely, would cause the other substrate to prohibit expansion of the one substrate, during implementation of the device forming step S4 in the high temperature. This might cause stresses on the semiconductor substrate K and the second substrate 12, and these stresses might become a defect such as a distortion and might be observed at the semiconductor substrate K or the second substrate 12. The stress occurring on the semiconductor substrate K might also become a cause for a defect at the element Gd such as an MOSFET or a Schottky diode formed in the semiconductor substrate K.

On the other hand, in the present embodiment, the semiconductor substrate K and the second substrate 12 are not coupled to each other inside the fixing part Q. Thus, when the device forming step S4 is performed in the high temperature, one substrate of the semiconductor substrate K and the second substrate 12 having the larger expansion coefficient is allowed to curve independently of the other substrate inside the fixing part Q. As a result, both of these two substrates become capable of expanding to respective degrees of expansion responsive to their own expansion coefficients. This makes it unlikely that a stress will occur on each of the semiconductor substrate K and the second substrate 12, so that it also becomes unlikely that a defect will occur at the element Gd such as an MOSFET or a Schottky diode formed in the semiconductor substrate K.

### <Cutting Step S5>

In the cutting step S5 (see FIG. 2), the semiconductor substrate K and the second substrate 12 are held by a holding sheet 14 while the semiconductor substrate K is placed in a posture of being pointed toward the holding sheet 14. Then, in this state, the second substrate 12 and the semiconductor substrate K are cut into ring shapes at positions inside the ring-shape fixing part Q and along the fixing part Q. More specifically, the second substrate 12 and the semiconductor substrate K are cut in such a manner that cutting lines thereof become cutting lines surrounding all the device regions Rd provided in the semiconductor substrate K. As a method of this cutting, a method such as a blade dicing method, a plasma etching method, or a laser ablation method may be used.

In the present embodiment, the semiconductor substrate K and the second substrate 12 are not coupled to each other inside the fixing part Q. Thus, as a result of the cutting inside the ring-shape fixing part Q, parts of the semiconductor substrate K and the second substrate 12 inside the cutting sites become divided from the fixing part Q. Specifically, these inside parts become released from the coupling by the fixing part Q. Furthermore, as a result of the cutting, the sealing in the ring shape provided by the fixing part Q is removed to eventually eliminate the attractive force generated as a result of the pressure difference between the inside pressure and the outside pressure. Thus, the part of the second substrate 12 inside the cutting site (hereinafter called an "inside part 121") becomes divided both from the fixing part Q and the semiconductor substrate K. In other words, the inside part 121 of the second substrate 12 is brought to a state easily detachable from the semiconductor substrate K.

### <Detaching Step S6>

In the detaching step S6 (see FIG. 2), the inside part 121 of the second substrate 12 is detached at an interface between the second substrate 12 and the metal layer 13 from the semiconductor substrate K. This allows the metal layer 13 to be exposed inside a ring-shape part 122 of the second substrate 12 left after the detaching (after the detaching of the inside part 121). The exposed metal layer 13 is thereafter removed using a method such as polishing or etching, thereby allowing the semiconductor substrate K to be exposed inside the ring-shape part 122.

If the metal layer 13 is formed on the surface 12a of the second substrate 12 instead of forming the metal layer 13 on the surface 11a of the first substrate 11 in the above-described fixing part forming step S2, the inside part 121 of the second substrate 12 can be detached at an interface between the metal layer 13 and the semiconductor substrate K from the semiconductor substrate K in the detaching step S6. In this case, it is possible to expose the semiconductor substrate K only by detaching the inside part 121 of the second substrate 12. Furthermore, if the metal layer 13 is formed only on a region of the surface 11a of the first substrate 11 over the periphery 112 or only on a region of the surface 12a of the second substrate 12 to face the periphery 112 in the metal layer forming step S21, the metal layer 13 is absent between the semiconductor substrate K and the second substrate 12 inside the periphery 112. Thus, in this case, it is also possible to expose the semiconductor substrate K only by detaching the inside part 121 of the second substrate 12.

### <Singulating Step S7>

In the singulating step S7 (see FIG. 2), while the semiconductor substrate K is kept held on the holding sheet 14, the semiconductor substrate K is subjected to cutting to individually singulate the device regions Rd provided in the semiconductor substrate K. More specifically, the semiconductor substrate K is cut along boundary lines Lb (see FIG. 3) for partitioning the device regions Rd to singulate the device regions Rd individually. As a method of this cutting, a method such as a blade dicing method, a plasma etching method, or a laser ablation method may be used. This results in manufacture of a plurality of semiconductor devices each including the element Gd such as an MOSFET or a Schottky diode.

As described above, according to the manufacturing method of the present embodiment, it is possible to firmly join the first substrate 11 and the second substrate 12 to each other by means of the joining force exerted by the ring-shape fixing part Q and the attractive force resulting from the pressure difference between a pressure in the ring shape (inside pressure) and a pressure outside the ring shape (outside pressure). This makes it possible to obtain joining force sufficient for holding the semiconductor substrate K on the second substrate 12 after the semiconductor substrate K is divided from the first substrate 11 in the dividing step S3 without the need of providing coupling between the first substrate 11 and the second substrate 12 over the entire areas of the respective joint surfaces (namely, without the need of performing joining using CMP) unlike in the conventional case. Furthermore, as the semiconductor substrate K and the second substrate 12 are not coupled to each other inside the fixing part Q, the inside part 121 of the second substrate 12 can be detached easily from the semiconductor substrate K by the cutting inside the ring-shape fixing part Q in the cutting step S5, and the semiconductor substrate K can be exposed by the detaching of the inside part 121.

Thus, according to the manufacturing method of the present embodiment, in the technique of manufacturing the semiconductor device including the process of forming the semiconductor substrate K using the dividing layer 111, handling of the semiconductor substrate K is facilitated after formation of the semiconductor substrate K (in the present embodiment, after implementation of the dividing step S3).

### [2] Modifications

### [2-1] First Modification

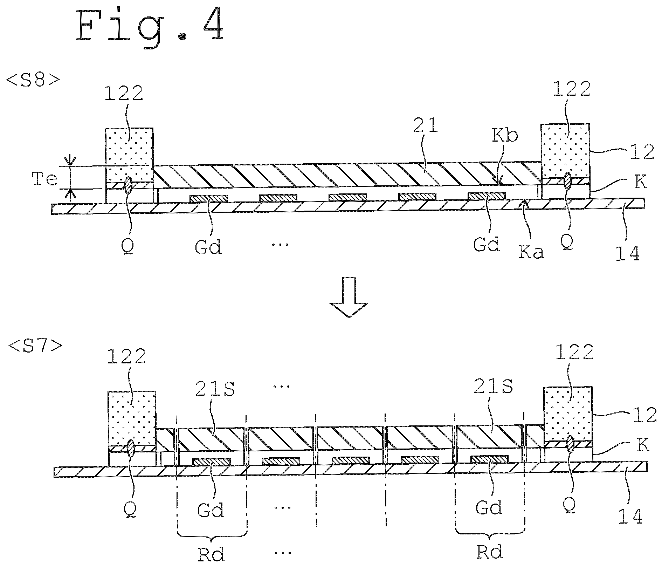

FIG. 4 is a conceptual view showing a manufacturing method according to a first modification in order in which processes are performed. In the above-described manufacturing method, a reinforcing layer forming step S8 may be performed after the detaching step S6 and before the singulating step S7. Further specifically, in the reinforcing layer forming step S8, a reinforcing layer 21 having a predetermined thickness Te is formed as a reinforcing substrate for the semiconductor substrate K, and is formed inside the ring-shape part 122 of the second substrate 12 left after the detaching (after the detaching of the inside part 121) and on a back surface Kb of the semiconductor substrate K (a surface that has been the surface 11a of the first substrate 11) opposite to the surface Ka of the semiconductor substrate K pointed toward the holding sheet 14. More specifically, the reinforcing layer 21 having the predetermined thickness Te can be formed by applying a reinforcing material (a thermoplastic material, for example) onto the back surface Kb of the semiconductor substrate K inside the ring-shape part 122 of the second substrate 12 using a coating method such as a spin coating method or a spray coating method. The reinforcing material may be an electrically-insulating material or a conductive material.

Then, in the singulating step S7, when the semiconductor substrate K is cut, the reinforcing layer 21 is further cut at the same position as a cutting position of the semiconductor substrate K in a plan view, thereby individually singulating the device regions Rd provided in the semiconductor substrate K. As a result, it is possible to manufacture a semiconductor device supported by a reinforcing substrate 21S.

### [2-2] Second Modification

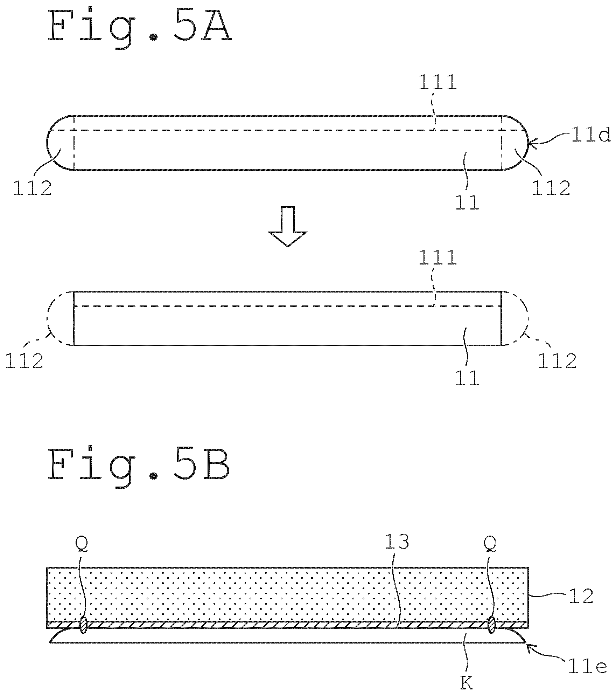

FIG. 5A is a conceptual view showing the dividing layer forming step S1 performed in a manufacturing method according to a second modification. In the above-described manufacturing method, a substrate having a rounded outer peripheral surface 11d (in other words, having the outer peripheral surface 11d formed as a convex surface) such as that shown in FIG. 5A may be used as the first substrate 11. Meanwhile, if the first substrate 11 having such a shape is used and if the dividing step S3 is performed directly after formation of the dividing layer 111, a sharp edge 11e occurs at an outer periphery of the semiconductor substrate K formed in the dividing step S3, as shown in FIG. 5B. A part with this sharp edge 11e causes a risk of damaging another member or being chipped to cause a defect at the semiconductor substrate K during the course of manufacturing a semiconductor device.

In response to this, as shown in FIG. 5A, the periphery 112 of the first substrate 11 (a rounded part of the outer peripheral surface 11d) may be cut off after formation of the dividing layer 111. Using the first substrate 11 as a new first substrate 11 from which the periphery 112 has been cut off, the processes from the fixing part forming step S2 described above may be performed. By cutting off the periphery 112 of the first substrate 11 (the rounded part of the outer peripheral surface 11d) in this way, it becomes possible to prevent the occurrence of the above sharp edge 11e at the outer periphery of the semiconductor substrate K.

In terms of preventing the occurrence of the above sharp edge 11e, instead of the method of cutting off the periphery 112 of the first substrate 11 (the rounded part of the outer peripheral surface 11d) after formation of the dividing layer 111, the dividing layer 111 may be formed after cutting off the periphery 112 of the first substrate 11 (the rounded part of the outer peripheral surface 11d).

### [2-3] Third Modification

In the above-described manufacturing method, in a case without a risk of a problem caused by the expansion of the substrate such as that described above (a problem that a stress caused by the expansion of the substrate is observed as a defect at the substrate or the element Gd without being relaxing) (in a case where the expansion coefficient of the semiconductor substrate K and the expansion coefficient of the second substrate 12 are equal to each other, for example) even if the device forming step S4 is performed in a high temperature, the following process may be performed after the dividing step S3.

According to the ring-shape fixing part Q formed in the fixing part forming step S2, the interior of the ring shape is sealed while being kept in a lower pressure than the predetermined pressure Pt. Thus, in an atmosphere at the predetermined pressure Pt or in an atmosphere at a higher pressure than the predetermined pressure Pt, a pressure difference can be generated between a pressure inside the ring shape of the fixing part Q (inside pressure) and a pressure outside the ring shape (outside pressure). This eventually makes it possible to generate attractive force resulting from the pressure difference and acting between the first substrate 11 and the second substrate 12. Thus, with this attractive force, it is possible to make tight contact between the first substrate 11 and the second substrate 12, or in the presence of the metal layer 13 interposed between these substrates, make tight contact of each of these substrates with the metal layer 13.

In this regard, after the dividing step S3, a thermal process on the semiconductor substrate K and the second substrate 12 may be performed while the above-described state of the tight contact is kept (namely, in the atmosphere at the predetermined pressure Pt or in the atmosphere at the higher pressure than the predetermined pressure Pt). By doing so, a compound (such as metal silicide) or an alloy (such as an alloy of metal and Si) of the metal as the main component of the metal layer 13 and the main component (such as semiconductor) of each of the first substrate 11 and the second substrate 12 may be generated at an interface between the semiconductor substrate K and the second substrate 12. As a result, the semiconductor substrate K and the second substrate 12 may be stuck to each other further in a region inside the fixing part Q.

Such a method of providing sticking further in the region inside the fixing part Q by means of the attractive force resulting from the pressure difference is also implementable in a case where a thermal process is performed in a low temperature of equal to or less than 1000°C (400°C, for example) (in a case such as eutectic bonding). In this case, even if the semiconductor substrate K has an expansion coefficient differing from the expansion coefficient of the second substrate 12, it is still possible to provide sticking in the region inside the fixing part Q without causing a large difference between respective degrees of expansion thereof. In other words, it is possible to provide sticking in the region inside the fixing part Q without causing a large stress resulting from a difference between the expansion coefficients. Thus, if the semiconductor substrate K and the second substrate 12 are to be stuck to each other over the entire areas of the joint surfaces and if the sticking over the entire areas of the joint surfaces will not cause an issue in a subsequent process (if the device forming step S4 is to be performed not in a high temperature, for example), it is possible to employ such a method of providing sticking further in the region inside the fixing part Q through a thermal process at a low temperature.

### [2-4] Fourth Modification

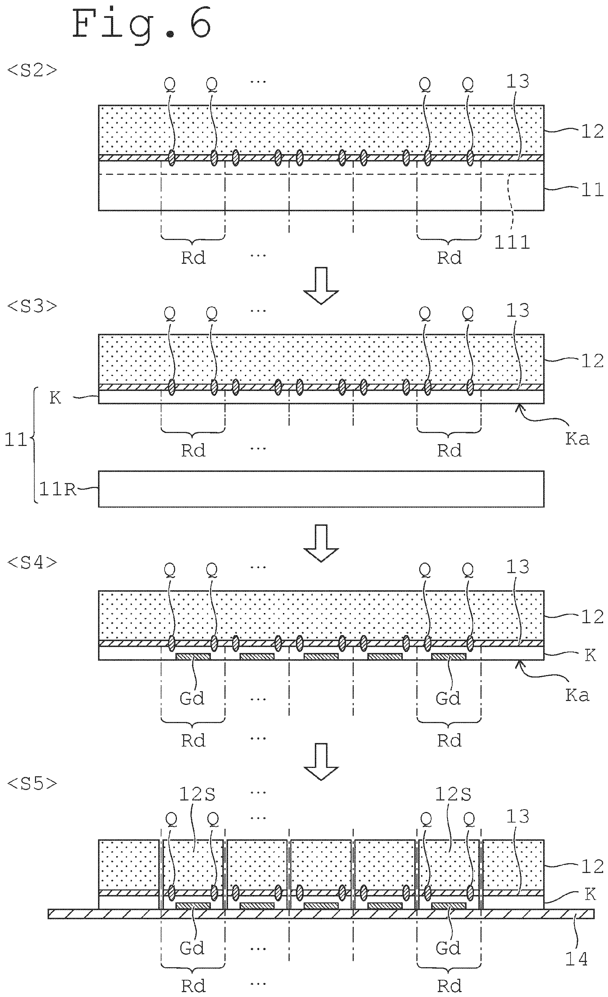

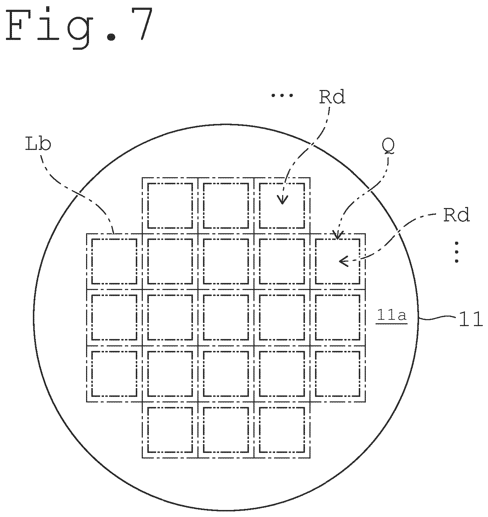

FIG. 6 is a conceptual view showing part of a manufacturing method according to a fourth modification in order in which processes are performed. FIG. 7 is a plan view showing the shape of the fixing part Q formed in this modification. In the above-described manufacturing method, in the fixing part forming step S2, the fixing part Q may be formed in each of the device regions Rd provided in the part of the first substrate 11 to become the semiconductor substrate K, and may be formed into a ring shape at a periphery of the device region Rd in such a manner as to be formed over an entire perimeter of the periphery. In doing this, the fixing part Q is formed continuously into a ring shape in an atmosphere at a lower pressure than the predetermined pressure Pt, so that the interior of the ring shape is sealed while being kept in the lower pressure than the predetermined pressure Pt. In the example in FIG. 7, each device region Rd has a quadrangular shape and the fixing part Q is formed into a quadrangular ring shape along the periphery of the device region Rd. The shape of the fixing part Q is not limited to a quadrangular ring shape but may be changed to a different ring shape (such as a circular shape or a polygonal shape), as appropriate, in response to the peripheral shape of each device region Rd.

According to the above formation of the fixing part Q, in an atmosphere at the predetermined pressure Pt, each device region Rd can generate a pressure difference between a pressure inside the ring shape of the fixing part Q (inside pressure) and a pressure outside the ring shape (outside pressure). As a result, attractive force resulting from the pressure difference and acting between the first substrate 11 and the second substrate 12 can be generated in each of a plurality of locations. Thus, in the atmosphere at the predetermined pressure Pt, the first substrate 11 and the second substrate 12 can be firmly joined to each other by means of joining force exerted by the fixing part Q and the attractive force resulting from the pressure difference between the inside pressure and the outside pressure. This makes it possible to obtain joining force sufficient for holding the semiconductor substrate K on the second substrate 12 after the semiconductor substrate K is divided from the first substrate 11 in the dividing step S3 without the need of providing coupling between the first substrate 11 and the second substrate 12 over the entire areas of the respective joint surfaces (namely, without the need of performing joining using CMP) unlike in the conventional case.

In the cutting step S5 performed after the dividing step S3 and the device forming step S4, the semiconductor substrate K and the second substrate 12 may be cut at a position between the fixing parts Q formed at corresponding two of the device regions Rd adjacent to each other while being held on the holding sheet 14, thereby allowing the device regions Rd provided in the semiconductor substrate K to be singulated individually. As a result, it is possible to manufacture a semiconductor device supported by a support substrate 12S (a substrate resulting from the cutting of the second substrate 12). At this time, each semiconductor device is supported while being firmly joined to the support substrate 12S by means of the joining force exerted by the ring-shape fixing part Q and the attractive force resulting from the pressure difference between the pressure in the ring shape (inside pressure) and the pressure outside the ring shape (outside pressure).

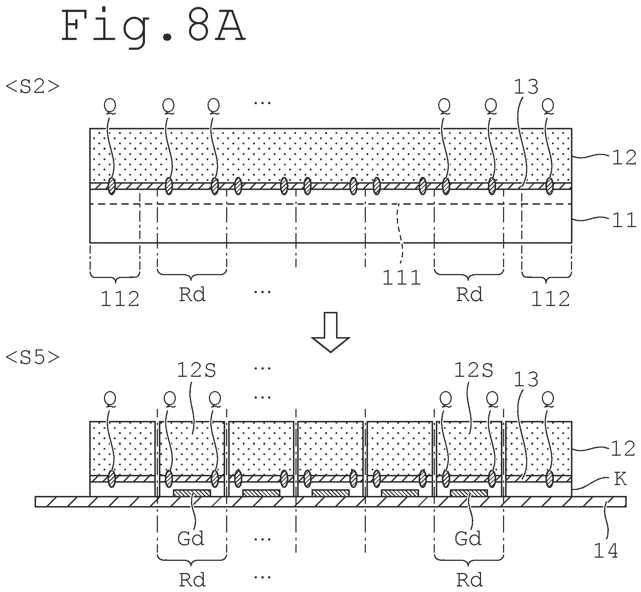

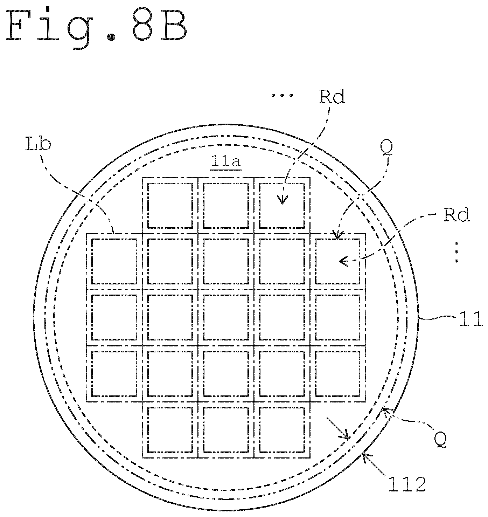

FIGS. 8A and 8B are a conceptual view and a plan view respectively showing a further modification of the above-described manufacturing method in FIGS. 6 and 7. As shown in FIGS. 8A and 8B, in addition to forming the ring-shape fixing part Q at the periphery of each device region Rd, the ring-shape fixing part Q may be formed further at the periphery 112 of the first substrate 11 (more specifically, a periphery of the part of the first substrate 11 to become the semiconductor substrate K) in such a manner as to be formed along the periphery 112.

In this configuration, using the ring-shape fixing part Q formed along the periphery 112, it is possible to reduce the occurrence of exfoliation or an unstable behavior at an end portion of the substrate during cutting in the cutting step S5.

### [2-5] Fifth Modification

In the above-described manufacturing method, the ring-shape fixing part Q formed in the fixing part forming step S2 is not limited to those having the shapes shown in FIG. 3 (embodiment) and FIG. 7 (fourth modification) but the fixing parts Q having the following shapes may be formed.

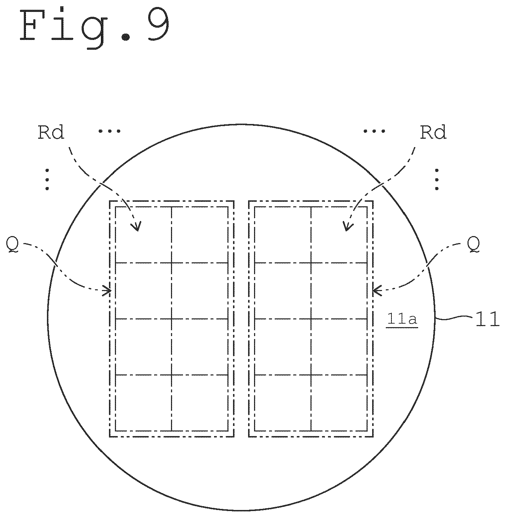

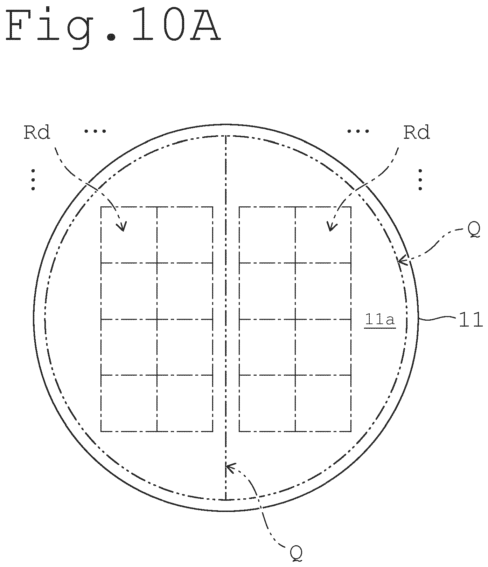

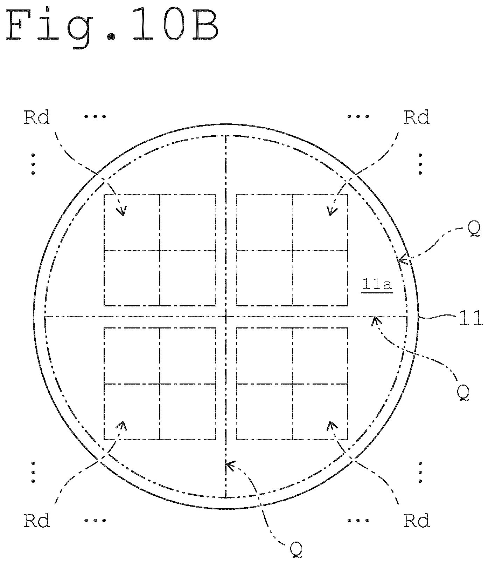

FIGS. 9, 10A, and 10B are plan views showing three examples of the shape of the fixing part Q formed in a fifth modification. As shown in these drawings, the device regions Rb may be separated into several groups, and the fixing part Q may be formed into a ring shape in such a manner as to have correspondence to each of the groups and surround all the device regions Rd in the corresponding group.

In an exemplary case shown in FIG. 9, the fixing parts Q are formed into independent ring shapes provided for the respective groups. In a case shown in each of FIGS. 10A and 10B, the fixing parts Q are formed by means of a combination of a circular portion and a straight portion so as to allow the fixing parts Q to be shared partially between the groups. More specifically, in the case shown in FIG. 10A, the fixing parts Q are composed of a circular portion formed into a ring shape along the periphery 112, and one straight portion traversing inside the circular portion. In this case, the straight portion is shared as straight parts of the fixing parts Q between the groups. As a result, two ring-shape portions each prepared for a corresponding one of the groups and capable of surrounding all the device regions Rd in the corresponding group are formed as the fixing parts Q. In the case shown in FIG. 10B, the fixing parts Q are composed of a circular portion formed into a ring shape along the periphery 112, and two straight portions traversing inside the circular portion and crossing each other (in the example in FIG. 10B, orthogonal to each other). Also in this case, the straight portions are shared as straight parts of the fixing parts Q between the groups. As a result, four ring-shape portions each prepared for a corresponding one of the groups and capable of surrounding all the device regions Rd in the corresponding group are formed as the fixing parts Q.

### [2-6] Sixth Modification

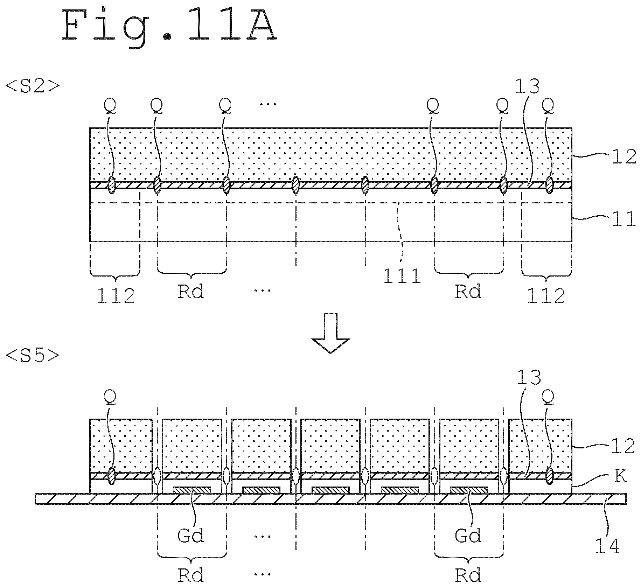

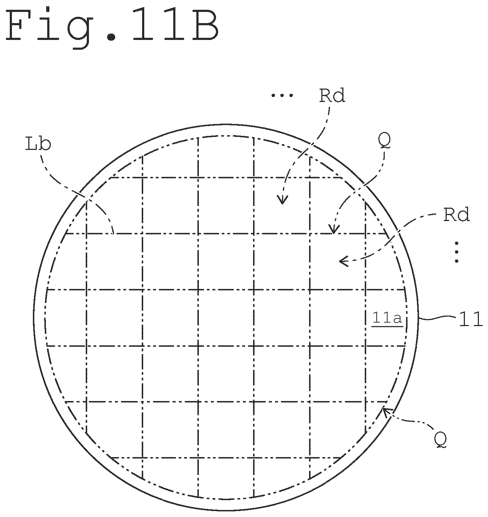

FIG. 11A is a conceptual view showing the fixing part forming step S2 and the cutting step S5 performed in a manufacturing method according to a sixth modification. FIG. 11B is a plan view showing the shape of the fixing part Q formed in the sixth modification.

In the above-described manufacturing method, in the fixing part forming step S2, the fixing part Q may be formed on the boundary lines Lb for partitioning of the device regions Rd provided in the first substrate 11. In an exemplary case in FIG. 10B, the fixing parts Q are composed of a circular portion formed into a ring shape along the periphery 112, and a plurality of straight portions forming a grid by traversing inside the circular portion and extending on the boundary lines Lb. By forming the grid of the straight portions in this way, a plurality of ring-shape portions each prepared for a corresponding one of the device regions Rb and surrounding the corresponding device region Rd are formed as the fixing parts Q.

If the fixing parts Q are formed on the boundary lines Lb for the device regions Rd in this way, by cutting the second substrate 12 and the semiconductor substrate K along the boundary lines Lb in the cutting step S5 (see FIG. 11A), it becomes possible to remove the fixing part Q together with parts of the second substrate 12 and the semiconductor substrate K removed during the cutting.

### [2-7] Seventh Modification

In the above-described manufacturing method, a method of forming the fixing part Q in the fixing part forming step S2 is not limited to the method of forming the fixing part Q by application of laser light to the metal layer 13 but may be changed, as appropriate, to a method of forming the fixing part Q by applying laser light to an interface between the first substrate 11 and the second substrate 12 while these substrates are in direct contact with each other.

### [2-8] Eighth Modification

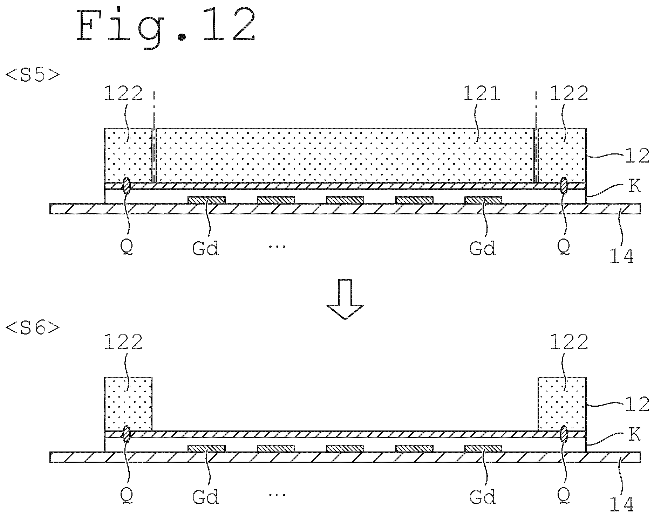

FIG. 12 is a conceptual view showing the cutting step S5 and the detaching step S6 performed in a manufacturing method according to an eighth modification. In the above-described manufacturing method according to the embodiment, of the second substrate 12 and the semiconductor substrate K, only the second substrate 12 may be cut into a ring shape at a position inside the ring-shape fixing part Q and along the fixing part Q in the cutting step S5. More specifically, only the second substrate 12 is cut in such a manner that cutting lines thereof become cutting lines surrounding all the device regions Rd provided in the semiconductor substrate K.

According to this cutting method, while the inside part 121 of the second substrate 12 becomes divided from the fixing part Q, the semiconductor substrate K is entirely kept connected to the fixing part Q. In other words, the semiconductor substrate K entirely becomes joined through the fixing part Q to the ring-shape part 122 of the second substrate 12 left after the detaching (after the detaching of the inside part 121).

Thus, by detaching the inside part 121 of the second substrate 12 from the semiconductor substrate K in the detaching step S6, it becomes possible to use the ring-shape part 122 of the second substrate 12 as a ring-shape support and obtain the semiconductor substrate K supported by this support.

### [2-9] Other Modifications

In the above-described manufacturing method, if attractive force resulting from a pressure difference between a pressure in the ring shape of the fixing part Q (inside pressure) and a pressure outside the ring shape (outside pressure) is not required, the shape of the fixing part Q can be changed, as appropriate, to various shapes not limited to a ring shape. For example, a dot shape or an open line-like shape (a line-like shape with ends) may be employed as the shape of the fixing part Q.

The above explanations of the embodiments and the modifications are nothing more than illustrative in any respect, nor should be thought of as restrictive. The scope of the present invention is indicated by claims rather than the above embodiments and modifications. Furthermore, it is intended that all changes that are equivalent to a claim in the sense and realm of the doctrine of equivalence be included within the scope of the present invention.

Some of the steps forming the method of manufacturing the semiconductor device may be extracted partially as subjects of the invention or each of the steps may be extracted individually as a subject of the invention from the above-described embodiments and modifications.

### Reference Signs List

K Semiconductor substrate
Q Fixing part
11 First substrate
11a Surface
11d Outer peripheral surface
11e Edge
11R Residual part
12 Second substrate
12a Surface
12S Support substrate
13 Metal layer
14 Holding sheet
21 Reinforcing layer
21S Reinforcing substrate
Dt Predetermined depth
Gd Element
Ka Surface
Kb Back surface
Lb Boundary line
Pt Predetermined pressure
Rd Device region
Td Thickness
Te Predetermined thickness
111 Dividing layer
112 Periphery
121 Inside part
122 Ring-shape part
S1 Dividing layer forming step
S2 Fixing part forming step
S3 Dividing step
S4 Device forming step
S5 Cutting step
S6 Detaching step
S7 Singulating step
S8 Reinforcing layer forming step
S21 Metal layer forming step
S22 Laser light applying step

## Claims

1. A method of manufacturing a semiconductor device comprising:
a dividing layer forming step that forms a dividing layer in a position at a predetermined depth from a surface of a first substrate containing semiconductor as a main component thereof, the dividing layer being for allowing a semiconductor substrate having a thickness corresponding to the predetermined depth to be divided from the first substrate;
a fixing part forming step that forms a fixing part for fixing a part of the first substrate to become the semiconductor substrate to a second substrate after the dividing layer forming step, the fixing part being formed into a ring shape in an atmosphere at a lower pressure than a predetermined pressure, thereby sealing the interior of the ring shape; and
a dividing step that divides the first substrate at the dividing layer in an atmosphere at the predetermined pressure after the fixing part forming step.

2. The method of manufacturing the semiconductor device according to claim 1, wherein
in the fixing part forming step, the fixing part is formed at a periphery of the part of the first substrate to become the semiconductor substrate in such a manner as to be formed over an entire perimeter of the periphery.

3. The method of manufacturing the semiconductor device according to claim 2, wherein
the fixing part forming step includes:
a metal layer forming step that forms a metal layer at least on a region of the surface of the first substrate over the periphery or at least on a region of a surface of the second substrate to face the periphery; and
a laser light applying step that interposes the metal layer between the first substrate and the second substrate, and in this state, applies laser light to a part of the metal layer on the periphery, thereby heating the part of the metal layer to form the fixing part.

4. The method of manufacturing the semiconductor device according to claim 2 or 3, further comprising:
a device forming step that forms at least a part of an element in each of a plurality of device regions provided in the semiconductor substrate after the dividing step, the element being to be provided to the semiconductor device; and
a cutting step that holds the semiconductor substrate and the second substrate using a holding sheet while placing the semiconductor substrate in a posture of being pointed toward the holding sheet after the device forming step, and in this state, cuts at least the second substrate at a position inside the ring-shape fixing part.

5. The method of manufacturing the semiconductor device according to claim 4, further comprising:
a detaching step that detaches a part of the second substrate inside the ring-shape fixing part from the semiconductor substrate after the cutting step.

6. The method of manufacturing the semiconductor device according to claim 5, further comprising:
a reinforcing layer forming step that forms a reinforcing layer having a predetermined thickness as a reinforcing substrate for the semiconductor substrate after the detaching step, the reinforcing layer being formed inside a ring-shape part of the second substrate left after the detaching and on a back surface of the semiconductor substrate opposite to a surface of the semiconductor substrate pointed toward the holding sheet.

7. The method of manufacturing the semiconductor device according to any one of claims 2 to 6, wherein
in the dividing layer forming step, a periphery of the first substrate is cut off after formation of the dividing layer, and
in the fixing part forming step, using the first substrate as a new first substrate from which the periphery has been cut off in the dividing layer forming step, the fixing part is formed at a periphery of a part of the new first substrate to become the semiconductor substrate in such a manner as to be formed over an entire perimeter of the periphery.

8. The method of manufacturing the semiconductor device according to claim 1, wherein
after the dividing step, the semiconductor substrate and the second substrate are subjected to a thermal process in the atmosphere at the predetermined pressure or in an atmosphere at a higher pressure than the predetermined pressure, thereby sticking the semiconductor substrate and the second substrate to each other in a region inside the fixing part.

9. The method of manufacturing the semiconductor device according to claim 1, wherein
in the fixing part forming step, the fixing part is formed in each of a plurality of device regions provided in the part of the first substrate to become the semiconductor substrate, and is formed at a periphery of the device region in such a manner as to be formed over an entire perimeter of the periphery.

10. The method of manufacturing the semiconductor device according to claim 9, wherein
the fixing part forming step includes:
a metal layer forming step that forms a metal layer on the surface of the first substrate or on a surface of the second substrate; and
a laser light applying step that interposes the metal layer between the first substrate and the second substrate, and in this state, applies laser light to a part of the metal layer on the periphery of each of the device regions, thereby heating the part of the metal layer to form the fixing part.

11. The method of manufacturing the semiconductor device according to claim 9 or 10, further comprising:
a device forming step that forms at least a part of an element in each of the device regions provided in the semiconductor substrate after the dividing step, the element being to be provided to the semiconductor device; and
a cutting step that holds the semiconductor substrate and the second substrate using a holding sheet while placing the semiconductor substrate in a posture of being pointed toward the holding sheet after the device forming step, and in this state, cuts the semiconductor substrate and the second substrate at a position between the fixing parts formed at corresponding two of the device regions adjacent to each other.
